(19) Europäisches Patentamt European Patent Office Office européen des brevets

(11) **EP 1 353 190 B1**

(12) **EUROPÄISCHE PATENTSCHRIFT**

(45) Veröffentlichungstag und Bekanntmachung des Hinweises auf die Patenterteilung:
**02.06.2010 Patentblatt 2010/22**

(51) Int Cl.:
***G01R 31/36*** *(2006.01)*

(21) Anmeldenummer: **03001151.4**

(22) Anmeldetag: **21.01.2003**

(54) **Verfahren zur Bestimmung des Verschleisses eines elektrochemischen Energiespeichers**

Method for determining the deterioration of an electro chemical energy storage device

Procédé pour la détermination de l'usure d'un dispositif de stockage d'énergie chimique

(84) Benannte Vertragsstaaten:
**DE ES FR GB IT**

(30) Priorität: **05.04.2002 DE 10215071**

(43) Veröffentlichungstag der Anmeldung:
**15.10.2003 Patentblatt 2003/42**

(73) Patentinhaber: **VB Autobatterie GmbH & Co. KGaA**
**30419 Hannover (DE)**

(72) Erfinder:
• **Meissner, Eberhard, Dr. Dipl.-Phys.**
**31515 Wunstorf (DE)**

• **Laig-Hörstebrock, Helmut, Dr. Dipl.-Phys.**
**60320 Frankfurt (DE)**

(74) Vertreter: **Rehmann, Thorsten et al**
**Gramm, Lins & Partner GbR**
**Theodor-Heuss-Strasse 1**
**38122 Braunschweig (DE)**

(56) Entgegenhaltungen:
**DE-A- 3 808 559    DE-A- 3 901 680**
**DE-A- 19 540 827    US-A- 5 596 262**
**US-A- 5 650 712**

**Beschreibung**

Die Erfindung betrifft ein Verfahren zur Bestimmung des Verschleißes eines elektrochemischen Energiespeichers durch Verlust an Speicherkapazität, sowie einen Energiespeicher, insbesondere eine Starterbatterie für Kraftfahrzeuge, mit Messmitteln zur Bestimmung der umgesetzten Ladungsmengen während der Ladezyklen des Energiespeichers und mit Rechenmitteln.

Energiespeicher, beispielsweise wiederaufladbare elektrochemische Speicherbatterien, unterliegen einem Verschleiß insbesondere beim Entlade- und Ladebetrieb. Neben dem Entlade- und Ladebetrieb gibt es auch andere, den Verschleiß von elektrochemischen Energiespeichern beschleunigende Betriebsbedingungen. Dazu gehört z. B. beim Bleiakkumulator die gesamte Betriebsdauer, d. h. die gesamte seit der Inbetriebnahme verstrichene Zeit einschließlich der Perioden, in denen der Akkumulator nicht elektrisch beaufschlagt wurde.

Weiterhin können erhöhte Temperaturen den Verschleiß während der Perioden ohne elektrische Beaufschlagung und den durch zyklischen Entlade- und Ladebetrieb hervorgerufenen Verschleiß verstärken.

Für den Einsatz von Energiespeichern ist es erwünscht, den Verschleiß aufgrund von Verlust an Speicherkapazität zu bestimmen. Hierbei stellt jedoch die Komplexität der Vorgänge im Energiespeicher ein Problem dar, die mit naturwissenschaftlichen Methoden nur schwer beschreibbar sind.

Beispielsweise aus der DE 195 40 827 C2 ist ein empirisches Verfahren zur Bestimmung des Alterungszustandes einer Batterie bekannt, bei der ein batteriespezifisches Kennfeld der Batteriealterung vorgegeben wird. Durch Erfassen von Momentanwerten der Batteriealterungseinflussgrößen bei der überwachten Batterie wird mit Hilfe des Kennfeldes ein Batteriealterungswert ermittelt.

Aus der DE 39 01 680 C3 ist ein Verfahren zur Überwachung der Kaltstartfähigkeit einer Starterbatterie bekannt, bei dem bei laufenden Verbrennungsmotor ständig die Ladespannung beobachtet und hinsichtlich des Über- oder Unterschreitens vorgegebener Grenzwerte überwacht wird. Auf diese Weise wird ein Defekt der Lichtmaschine erkannt. Zudem wird der zeitliche Verlauf des Spannungsabfalls an den Anschlussklemmen des elektrischen Anlassers während des Startvorgangs beobachtet und ausgewertet. Eine Aussage über die verfügbare Speicherkapazität des Energiespeichers kann hierbei jedoch nicht getroffen werden.

In der DE 38 08 559 C2 ist ein Verfahren zur Überwachung der Leistungsgrenze einer Starterbatterie offenbart, bei dem durch Aufsummieren der zugeflossenen und abgeflossenen Ladungsmenge eine Ladungsmengenbilanz erstellt wird. Hieraus wird in Verbindung mit der Überwachung einer Grenz-Klemmenspannung und der Temperatur der Ladezustand der Starterbatterie bewertet. Auch hier kann keine Aussage über die verbleibende maximale Speicherkapazität des Energiespeichers getroffen werden.

Aufgabe der Erfindung war es daher, ein Verfahren zur Bestimmung des Verschleißes eines elektrochemischen Energiespeichers durch Verlust an Speicherkapazität zu schaffen, mit dem eine Verschleißgröße als Maß für den Verlust an Speicherkapazität mit einfachen Mitteln zuverlässig berechnet werden kann.

Die Aufgabe wird erfindungsgemäß gelöst durch

- fortlaufende Ermittlung der umgesetzten Ladungsmengen während der Ladezyklen des Energiespeichers, und

- Berechnen einer den Verlust an Speicherkapazität kennzeichnenden Verschleißgröße als Funktion der ermittelten umgesetzten Ladungsmenge.

Es hat sich überraschend gezeigt, dass der Verschleiß eines Energiespeichers einfach und genau durch Betrachtung der in den Energiespeicher eingeladenen Ladungsmenge ermittelt werden kann. Dies lässt sich damit erklären, dass der Ladevorgang die den Verschleiß des Energiespeichers hervorrufenden strukturellen Veränderungen in den elektrochemisch aktiven Materialien bestimmt und zudem die verschleißträchtige Überladungen berücksichtigt werden. Dabei wurde erkannt, dass der Verlust an Speicherfähigkeit progressiv mit zunehmender Menge an umgesetzter Ladung während der Ladezyklen zunimmt und die Entladezyklen auf diesen Verlust keinen wesentlichen Einfluss haben.

Die umgesetzten Ladungsmengen werden vorzugsweise aus der Summe der in den Energiespeicher eingespeisten Ladungen, beispielsweise durch fortlaufende Integration des in den Energiespeicher fließenden Ladestroms oder durch Erfassen von Ladezustandsänderungen des Energiespeichers ermittelt.

Es wurde weiterhin erkannt, dass sehr kleine Ladungsdurchsätze in Lade- oder Entladerichtung, die sich abwechseln, nur wenig oder gar nicht zum Verschleiß des Energiespeichers beitragen. Die in die Berechnung der Verschleißgröße einfließende umgesetzten Ladungsmengen sollten daher größer als eine definierte Mindestladungsmenge pro Ladezyklus sein. Kleine Beiträge zum Ladungsdurchsatz werden somit bei der Ermittlung des Verschleißes nicht berücksichtigt. Die Mindestladungsmenge liegt vorzugsweise im Bereich des $0,1$ bis $1 \cdot 10^{-6}$-fachen, besonders bevorzugt im Bereich des $0,01$ bis $0,001$-fachen der Anfangskapazität eines gleichwertigen neuwertigen Energiespeichers.

Die Verschleißgröße kann beispielsweise proportional zu einer Verschleißfunktion bestimmt werden, die aus der Summe mindestens der Terme $a_0$, $a_1 \cdot q^k$ und $a_2 \cdot q^l$ besteht ($f(q) = a_0 + a_1 \cdot q^k + a_2 \cdot q^l$). Die Parameter $a_0$, $a_1$ und $a_2$ sind hierbei konstant. Die Variable q bezeichnet die umgesetzten Ladungsmengen und die Parameter k sind Werte kleiner oder gleich eins und l Werte größer eins.

Besonders vorteilhaft ist es, wenn die Verschleißfunktion in eine Potenzreihe in einem Entwicklungspunkt $q_0$ entwickelt wird, die aus einer Summe von mindestens den Termen $a_1 \cdot (q-q_0)^k$ und $a_2 \cdot (q-q_0)^l$ und einer Konstanten $a_0$ besteht. Die Parameter $a_1$ und $a_2$ sind konstant. Die Variable q bezeichnet wiederum die umgesetzte Ladungsmenge und die Parameter k sind Werte kleiner oder gleich eins und l Werte größer eins.

Die Verschleißfunktion kann auch in eine Taylorreihe im Entwicklungspunkt $q_0$ entwickelt werden, die aus einer Summe mindestens der des konstanten Wertes $f(q_0)$ der Verschleißfunktion im Entwicklungspunkt $q_0$ und mindestens

den Termen $f'(q_0) \cdot (q-q_0)$ und $\dfrac{f''(q_0)}{2} \cdot (q-q_0)^2$ besteht. Die Konstante $f'(q_0)$ ist die erste Ableitung der Verschleißfunktion im Entwicklungspunkt $q_0$ und $f''(q_0)$ die zweite Ableitung.

Die Verschleißgröße wird vorzugsweise proportional zu der Anfangskapazität eines gleichartigen neuwertigen Energiespeichers, beispielsweise aus dem Produkt der Verschleißfunktion und der Anfangskapazität, bestimmt. Sie kann jedoch auch proportional zu der Kapazität eines gleichartigen Energiespeichers zu einem anderen Betriebszeitpunkt sein.

Für einen Blei-Starterakkumulator wurde beispielsweise eine Verschleißfunktion $f(q) = 0,0013 \cdot q_L + 4 \cdot 10^{-5} \cdot q_L^2$ als geeignet zur Bestimmung des Verschleißes bestimmt, wobei die Ladungsmenge $q_L$ in Einheiten der Nennkapazität des Blei-Starterakkumulators gemessen wird.

Besonders vorteilhaft ist es, einen Kennwert für die aktuelle Speicherfähigkeit des Energiespeichers aus der Differenz zwischen der Anfangskapazität eines gleichwertigen neuwertigen Energiespeichers und der Verschleißgröße zu ermitteln. Dieser Kennwert für die aktuelle Speicherfähigkeit kann angezeigt, für weitere Berechnungen herangezogen oder als Regelparameter verwendet werden.

In einer Weiterbildung des erfindungsgemäßen Verfahrens kann die Verschleißgröße noch mit weiteren Zustandsgrößen verknüpft werden, die den Zustand des Energiespeichers beschreiben und mit herkömmlichen Methoden bestimmt werden. Solche Zustandsgrößen können z. B. die gesamte Betriebsdauer des Energiespeichers, die Temperatureinflüsse, der Ladzustand, die Leistungsbereitschaft etc. sein.

Die Aufgabe wird weiterhin durch den gattungsgemäßen Energiespeicher mittels Rechenmitteln gelöst, die zum Berechnen einer den Verlust an Speicherkapazität kennzeichnenden Verschleißgröße als Funktion der ermittelten umgesetzten Ladungsmenge nach dem oben beschriebenen Verfahren ausgebildet sind.

Die Erfindung wird nachfolgend anhand der beigefügten Zeichnung näher erläutert. Es zeigt:

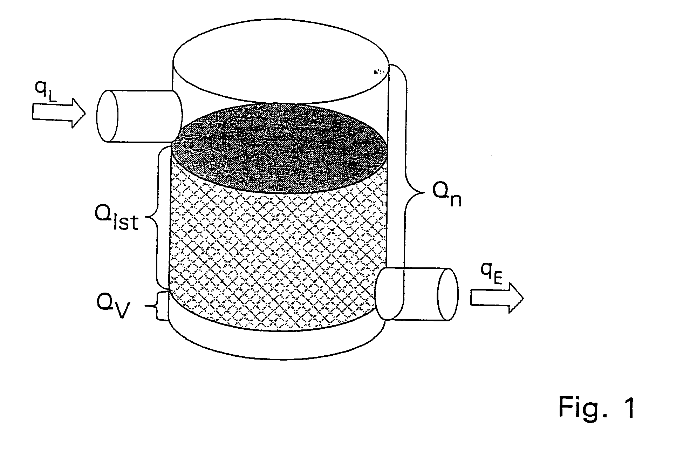

Figur 1 - Modelldarstellung eines elektrochemischen Energiespeichers.

Wiederaufladbare elektrochemische Energiespeicher werden im Allgemeinen in zwei unterschiedlichen Betriebsarten eingesetzt.

In einem reinen Lade-/Entladebetrieb wechseln sich zeitlich gegeneinander abgegrenzte Lade- und Entladephasen ab. Die Ladephase wird dabei meist solange fortgesetzt bis ein definierter Zustand, bevorzugt der Vollladezustand, erreicht ist. Dann folgt oftmals zu einem späteren Zeitpunkt, eine Entladephase, deren Ende entweder durch das Ende des Energiebedarfes oder durch die Erschöpfung des Energiespeichers festgelegt ist.

In einem Wechselbetrieb aus Lade- und Entladephasen können die Phasenlängen und die dabei umgesetzten Ladungsmengen sehr unterschiedlich sein. Im Normalfall wird weder der Volllade- noch der Erschöpfungszustand des Energiespeichers erreicht.

Der reine Lade-/Entladebetrieb ist z. B. für Elektrofahrzeuge wie Gabelstapler, für Taschenlampen und tragbare elektronische Geräte, wie Laptops, Mobiltelefone und Camcorder etc., typisch. Der Wechselbetrieb tritt hingegen bei der Bordnetzbatterie in Kraftfahrzeugen oder generell in sogenannten Inselbetrieben auf, wie sie beispielsweise in anderen Verkehrsmitteln, wie Schiffen, Bahnen, Luftund Raumfahrzeugen, oder in batteriegestützten lokalen Energienetzen, die beispielsweise durch Brennstoff, Solar- oder Windkraft versorgt werden, vorkommen.

Im reinen Lade-/Entladebetrieb folgen meist relativ große Ladungsdurchsätze bezogen auf die Speicherfähigkeit des Energiespeichers abwechselnd in Lade- und Entladerichtung aufeinander. Im Wechselbetrieb kommen hingegen oft sehr kleine Ladungsdurchsätze in Lade- oder Entladerichtung vor, bevor sich das Vorzeichen des durch den Energiespeicher fließenden Stromes wieder umkehrt.

Die Figur 1 lässt eine Skizze eines Energiespeichers erkennen, in den im Ladezyklus eine Ladungsmenge $q_L$ eingespeist und in einem Entladezyklus eine Entladungsmenge $q_E$ entnommen wird. Der Energiespeicher hat im Neuzustand eine Anfangskapazität $Q_n$ zum Speichern von Ladung. Während der Betriebsdauer nimmt die verfügbare Speicherkapazität $Q_{ist}$ aufgrund Verschleiß ab. Die Verschleißgröße $Q_v$ kennzeichnet den Verlust an verfügbarer Speicher-

kapazität $Q_{ist}$.

Es wurde nun festgestellt, dass der Verschleiß als Verlust an verfügbarer Speicherkapazität $Q_{ist}$ mit zunehmender umgesetzter Ladungsmenge im Ladebetrieb fortschreitet, wobei das Fortschreiten des Verschleißes progressiv erfolgt. Der Durchsatz einer gleichen Menge an Ladung führt damit zu einem umso höheren Verschleiß, je mehr Ladung bereits insgesamt durchgesetzt wurde.

Weiterhin hat sich herausgestellt, dass sehr kleine Ladungsumsätze in Lade- oder Entladerichtung, die sich abwechseln, den Verschleiß des Energiespeichers kaum beeinflussen. Dies liegt primär daran, dass sehr kleine Ladungsumsätze nur teilweise oder gar nicht zu elektrochemischen Reaktionen im elektrochemischen Energiespeicher führen, sondern zumindest teilweise von anderen Prozessen, wie z. B. der Umladung der Helmholtzschen Doppelschicht zwischen Festkörper und Elektrolyt, getragen werden. Bei der zur Bestimmung des Verschleißes berücksichtigten umgesetzten Ladungsmenge $q_L$ werden daher nur solche Ladungsmengen $q_L$ mit einbezogen, die innerhalb eines Ladezyklusses eine Mindestladungsmenge $q_{min}$ im Bereich des 0,1 bis $1 \cdot 10^{-6}$ -fachen der Anfangskapazität $Q_n$ eines gleichwertigen neuwertigen Energiespeichers überschreiten. Vorzugsweise sollte die umgesetzte Ladungsmenge $q_L$ eine Mindestladungsmenge $q_{min}$ im Bereich des 0,01 bis 0,001-fachen der Anfangskapazität $Q_n$ überschreiten.

Die während eines Ladungszyklusses umgesetzte Ladungsmenge wird beispielsweise durch Integration des gemessenen, berechneten oder geschätzten Stroms bestimmt. Alternativ kann die umgesetzte Ladungsmenge $q_L$ durch Messung, Berechnung oder Schätzung einer Änderung des Ladezustandes, die z. B. aus einer Messung der Ruhespannung oder einer anderen Spannung abgeleitet werden kann, erfolgen.

Die Verschleißgröße $Q_V$ wird dann als Funktion $f(q_L)$ der ermittelten umgesetzten Ladungsmenge $q_L$ bestimmt.

Die Funktion kann beispielsweise aus der Summe mindestens der Terme $a_0$, $a_1 \cdot q^k$ und $q_2 \cdot q^l$:

$$f(q) = a_0 + a_1 \cdot q^k + a_2 \cdot q^l$$

bestehen. Hierbei sind $a_0$, $a_1$ und $a_2$ konstante Parameter. Der Parameter k ist so definiert, dass er Werte kleiner oder gleich eins annimmt und der Parameter I größer eins ist.

In einer besonderen Ausgestaltung des Verfahrens ist die Verschleißfunktion definiert zu

$$f(q_L) = a_1 \cdot q_L + a_2 \cdot q_L^2.$$

Für einen Blei-Starterakkumulator wurden die Koeffizienten $a_1 = 0,0013$ und $a_2 = 4 \cdot 10^{-5}$ als Optimalwerte gefunden.

Die Verschleißfunktion $f(q)$ kann auch in eine Potenzreihe im Entwicklungspunkt $q_0$ entwickelt werden und mindestens aus der folgenden Summe bestehen:

$$f(q) = a_0 + a_1 \cdot (q-q_0)^k + a_2 \cdot (q-q_0)^l.$$

Hierbei sind $a_0$, $a_1$ und $a_2$ wiederum konstante Parameter und die Parameter k sind für Werte kleiner oder gleich 1 und eins für Werte größer eins definiert.

Die Verschleißfunktion $f(q)$ kann auch in eine Taylorreihe im Entwicklungspunkt $q_0$ entwickelt werden, die mindestens die folgende Summe aufweist:

$$f(q) = f'(q_0) \cdot (q-q_0) + \frac{f''(q_0)}{2} \cdot (q-q_0)^2.$$

Die Verschleißgröße $Q_V$ wird dann vorzugsweise aus dem Produkt der Verschleißfunktion $f(q_L)$ und der Anfangskapazität $Q_n$ berechnet.

Die aktuell verfügbare Speicherkapazität $Q_{ist}$ berechnet sich aus der Differenz der Anfangskapazität $Q_n$ und der Verschleißgröße $Q_V$:

$$Q_{ist} = Q_n - Q_v = Q_n (1 - f(q_L)).$$

**Patentansprüche**

1. Verfahren zur Bestimmung des Verschleißes eines elektrochemischen Energiespeichers, mit den Schritten

   - fortlaufende Ermittlung der umgesetzten Ladungsmengen ($q_L$) während der Ladezyklen des Energiespeichers und
   - Berechnen einer den Verschleiß kennzeichnenden Verschleißgröße ($Q_v$) als Funktion der ermittelten, umgesetzten Ladungsmenge ($q_L$),

   **gekennzeichnet durch** Ermitteln der umgesetzten Ladungsmenge ($q_L$) aus der Summe der in den Energiespeicher eingespeisten Ladungen.

2. Verfahren nach Anspruch 1, **dadurch gekennzeichnet, dass** der in den Energiespeicher fließende Ladestrom ($I_L$) fortlaufend zur Ermittlung der umgesetzten Ladungsmenge ($q_L$) integriert wird.

3. Verfahren nach Anspruch 1 oder 2, **gekennzeichnet durch** Erfassen von Ladezustandsänderungen des Energiespeichers zur Bestimmung der umgesetzten Ladungsmengen ($q_L$).

4. Verfahren nach einem der vorhergehenden Ansprüche, **dadurch gekennzeichnet, dass** die in die Berechnung der Verschleißgröße ($Q_v$) einfließenden umgesetzten Ladungsmengen ($q_L$) größer als eine definierte Mindestladungsmenge ($q_{min}$) pro Ladezyklus sind.

5. Verfahren nach Anspruch 4, **dadurch gekennzeichnet, dass** die Mindestladungsmenge ($q_{min}$) im Bereich des 0,1 bis 1 $10^{-6}$-fachen der Anfangskapazität ($Q_n$) eines gleichwertigen neuwertigen Energiespeichers ist.

6. Verfahren nach Anspruch 5, **dadurch gekennzeichnet, dass** die Mindestladungsmenge ($q_{min}$) im Bereich des 0,01 bis 0,001-fachen der Anfangskapazität ($Q_n$) eines neuwertigen Energiespeichers ist.

7. Verfahren nach einem vorhergehenden Ansprüche, **dadurch gekennzeichnet, dass** die Verschleißgröße ($Q_v$) proportional zu einer Verschleißfunktion ($f(q)$) ist, wobei die Verschleißfunktion ($f(q)$) aus der Summe mindestens der Terme $a_0$, $a_1 \cdot q^k$ und $\cdot a_2 q^l$ besteht ($f(q) = a_0 + a_1 \cdot q^k + a_2 \cdot q^l$), wobei $a_0$, $a_1$ und $a_2$ konstante Parameter, $q$ die umgesetzte Ladungsmenge und der Parameter $k$ kleiner oder gleich eins und der Parameter $l$ größer eins ist.

8. Verfahren nach einem der Ansprüche 1 bis 6, **dadurch gekennzeichnet, dass** die Verschleißgröße ($Q_v$) proportional zu einer Verschleißfunktion ($f(q)$) ist, wobei die Verschleißfunktion ($f(q)$) in eine Potenzreihe im Entwicklungspunkt ($q_0$) entwickelt wird, die aus einer Summe von mindestens den Termen $a_1 \cdot (q-q_0)^k$ und $a_2 (q-q_0)^l$ und einer Konstanten $a_0$ besteht, wobei $a_1$ und $a_2$ konstante Parameter, $q$ die umgesetzte Ladungsmenge, und der Parameter $k$ kleiner oder gleich eins und der Parameter $l$ größer eins ist.

9. Verfahren nach einem der vorhergehenden Ansprüche, **dadurch gekennzeichnet, dass** die Verschleißgröße ($Q_v$) proportional zu einer Verschleißfunktion ($f(q)$) in eine Taylorreihe im Entwicklungspunkt ($q_0$) entwickelt wird, die aus einer Summe des konstanten Wertes ($f(q_0)$) der Verschleißfunktion ($f(q)$) im Entwicklungspunkt ($q_0$) und mindestens den Termen $f'(q_0) \cdot (q-q_0)$ und $\dfrac{f''(q_0)}{2} \cdot (q-q_0)^2$ besteht, wobei $f'(q_0)$ die erste Ableitung der Verschleißfunktion ($f(q)$) im Entwicklungspunkt ($q_0$) und $f''(q_0)$ die zweite Ableitung der Verschleißfunktion ($f(q)$) im Entwicklungspunkt ($q_0$) ist.

10. Verfahren nach einem der vorhergehenden Ansprüche, **dadurch gekennzeichnet, dass** die Verschleißgröße ($Q_v$) proportional zu der Anfangskapazität ($Q_n$) eines gleichartigen neuwertigen Energiespeichers ist.

**11.** Verfahren nach einem der Ansprüche 7 bis 10, **gekennzeichnet durch** Berechnen der Verschleißgröße ($Q_v$) aus dem Produkt der Verschleißfunktion (f(q)) und der Anfangskapazität ($Q_n$) des gleichartigen neuwertigen Energiespeichers.

**12.** Verfahren nach einem der vorhergehenden Ansprüche, **gekennzeichnet durch** Ermitteln eines Kennwertes für die aktuelle Speicherfähigkeit ($Q_{ist}$) des Energiespeichers aus der Differenz zwischen der Anfangskapazität ($Q_n$) des gleichartigen neuwertigen Energiespeichers und der Verschleißgröße ($Q_v$).

**13.** Verfahren nach einem der vorhergehenden Ansprüche, **gekennzeichnet durch** Verknüpfen der Verschleißgröße ($Q_v$) mit weiteren Zustandsgrößen, die den Zustand des Energiespeichers beschreiben.

**14.** Energiespeicher, insbesondere Starterbatterie für Kraftfahrzeuge, mit Messmitteln zur Bestimmung der umgesetzten Ladungsmengen ($q_L$) während der Ladezyklen des Energiespeichers und mit Rechenmitteln, **dadurch gekennzeichnet, dass** die Rechenmittel zum Berechnen einer den Verlust an Speicherkapazität kennzeichnenden Verschleißgröße ($Q_v$) als Funktion der ermittelten umgesetzten Ladungsmenge ($q_L$) nach dem Verfahren nach einem der vorhergehenden Ansprüche ausgebildet sind.

**Claims**

**1.** A method for determining the wear to an electrochemical energy store, comprising

- continuously determining the amounts of charge ($q_L$) converted during the charging cycles of the energy store,
- calculating a wear variable ($Q_v$) which characterizes the wear as a function of the determined converted amount of charge ($q_L$), distinguished by determining the converted amount of charge ($q_L$) from the sum of the amounts of charge fed into the energy store.

**2.** The method as claimed in claim 1, wherein the charging current ($I_L$) which flows into the energy store is integrated continuously in order to determine the amount of charge ($q_L$) converted.

**3.** The method as claimed in claim 1 or 2, distinguished by detecting state of charge changes in the energy store in order to determine the amounts of charge ($q_L$) converted.

**4.** The method as claimed in one of the preceding claims, wherein the amounts of charge ($q_L$) which are converted and are included in the calculation of the wear variable ($Q_v$) are greater than a defined minimum amount of charge ($q_{min}$) per charging cycle.

**5.** The method as claimed in claim 4, wherein the minimum amount of charge ($q_{min}$) is in the range from 0.1 to $1 \times 10^{-6}$ times the initial capacity ($Q_n$) of an equivalent new energy store.

**6.** The method as claimed in claim 5, wherein the minimum amount of charge ($q_{min}$) is in the range from 0.01 to 0.001 times the initial capacity ($Q_n$) of a new energy store.

**7.** The method as claimed in one of the preceding claims, wherein the wear variable ($Q_v$) is proportional to a wear function (f(q)), with the wear function (f(q)) comprising the sum of at least the terms $a_0$, $a_1 \times q^k$ and $a_2 \times q^l$, ($f(q) = a_0 + a_1 \times q^k + a_2 \times q^l$), where $a_0$, $a_1$ and $a_2$ are constant parameters, q is the amount of charge converted and the parameter k is less than or equal to unity, and the parameter l is greater than unity.

**8.** The method as claimed in one of claims 1 to 6, wherein the wear variable ($Q_v$) is proportional to a wear function (f(q)), with the wear function (f(q)) being developed as a power series at the development point ($q_0$), which comprises a sum of at least the terms $a_1 \times (q-q_0)^k$ and $a_2 \times (q-q_0)^l$ and a constant $a_0$, where $a_1$ and $a_2$ are constant parameters, q is the amount of charge converted, and the parameter k is less than or equal to unity, and the parameter l is greater than unity.

**9.** The method as claimed in one of the preceding claims, wherein the wear variable ($Q_v$) is developed proportionally to a wear function (f(q)) into a Taylor series at the development point ($q_0$), which comprises a sum of the constant value ($f(q_0)$) of the wear function (f(q)) at the development point ($q_0$) and at least the terms $f'(q_0) \times (q-q_0)$ and

$$\frac{f''(q_0)}{2} \times (q-q_0)^2,$$ where $f'(q_0)$ is the first derivative of the wear function ($f(q)$) at the development point ($q_0$)

and $f''(q_0)$ is the second derivative of the wear function ($f(q)$) at the development point ($q_0$).

10. The method as claimed in one of the preceding claims, wherein the wear variable ($Q_v$) is proportional to the initial capacity ($Q_n$) of an equivalent new energy store.

11. The method as claimed in one of claims 7 to 10, distinguished by calculation of the wear variable ($Q_v$) from the product of the wear function ($f(q)$) and the initial capacity ($Q_n$) of the equivalent new energy store.

12. The method as claimed in one of the preceding claims, distinguished by determination of a characteristic value for the present storage capacity ($Q_{act}$) of the energy store from the difference between the initial capacity ($Q_n$) of the equivalent new energy store and the wear variable ($Q_v$).

13. The method as claimed in one of the preceding claims, distinguished by the wear variable ($Q_v$) being linked to further state variables which describe the state of the energy store.

14. An energy store, in particular a starter battery for motor vehicles, having measurement means for determining the amounts of charge ($q_L$) converted during the charging cycles of the energy store, and having computation means, wherein the computation means are designed to calculate a wear variable ($Q_v$), which characterizes the loss of storage capacity, as a function of the determined amount of charge ($q_L$) converted, using the method as claimed in one of the preceding claims.

**Revendications**

1. Procédé pour déterminer l'usure d'un accumulateur électrochimique d'énergie comprenant les étapes suivantes :

   - détermination en continu des quantités de charge ($q_L$) au cours des cycles de charge de l'accumulateur d'énergie, et
   - calcul d'une grandeur d'usure ($Q_v$) caractérisant l'usure en fonction de la quantité de charge ($q_L$) convertie, déterminée,

   **caractérisé en ce qu'**
   on détermine la quantité de charge convertie ($q_L$) à partir de la somme des charges accumulées dans l'accumulateur d'énergie.

2. Procédé selon la revendication 1,
   **caractérisé en ce qu'**
   on intègre en continu le courant de charge ($I_L$) passant dans l'accumulateur d'énergie pour déterminer la quantité de charge convertie ($q_L$).

3. Procédé selon la revendication 1 ou 2,
   **caractérisé en ce qu'**
   on saisit les variations d'état de charge de l'accumulateur d'énergie, pour déterminer les quantités de charge converties ($q_L$).

4. Procédé selon l'une des revendications précédentes,
   **caractérisé en ce que**
   les quantités de charge ($q_L$) converties entrant dans le calcul de la grandeur d'usure ($Q_v$), sont supérieures à une quantité de charge minimale ($q_{min}$), définie par cycles de chargement.

5. Procédé selon la revendication 4,
   **caractérisé en ce que**
   la quantité de charge minimale ($q_{min}$) se situe dans une plage comprise entre 0,1 et $1 \cdot 10^{-6}$ fois la capacité initiale ($Q_n$) d'un accumulateur d'énergie nouveau, de caractéristiques équivalentes.

**6.** Procédé selon la revendication 5,
**caractérisé en ce que**
la quantité minimale de charge ($q_{min}$) se situe dans une plage de 0,01 jusqu'à 0,001 fois la capacité initiale ($Q_n$) d'un accumulateur d'énergie nouveau.

**7.** Procédé selon l'une des revendications précédentes,
**caractérisé en ce que**
la grandeur d'usure ($Q_v$) est proportionnelle à une fonction d'usure (f(q)),
la fonction d'usure (f(q)) se compose de la somme au moins des termes $a_0$, $a_1$ $q^k$ et $a_2$ $q^l$, (f(q) = $a_0$ + $a_1$ - $q^k$ + $a_2$ $q^l$), relation dans laquelle $a_0$, $a_1$ et $a_2$ sont des paramètres constants, q est la quantité de charge convertie et le paramètre k est inférieur ou égal à l'unité et le paramètre l est supérieur à l'unité.

**8.** Procédé selon l'une des revendications 1 à 6,
**caractérisé en ce que**
la grandeur d'usure ($Q_v$) est proportionnelle à une fonction d'usure (f(q)),
la fonction d'usure (f(q)) étant développée suivant une série de puissances au point de développement ($q_0$), et se compose d'une somme comprenant au moins les termes suivants : $a_1$ $(q-q_0)^k$ et $a_2 \cdot (q-q_0)^1$ et une constante $a_0$, $a_1$ et $a_2$ étant des paramètres constants, q étant la quantité de charge convertie et le paramètre k est inférieur ou égal à l'unité et le paramètre l est supérieur à l'unité.

**9.** Procédé selon l'une des revendications précédentes,
**caractérisé en ce que**
la grandeur d'usure ($Q_v$) est proportionnelle à une fonction d'usure (f(q)) d'une série de Taylor au point de développement ($q_0$), qui est la somme de la valeur constante (f($q_0$)) de la fonction d'usure (f(q)) au point de développement et d'au moins l'un des termes suivants :

$$f'(q_0) \cdot (q-q_0) \text{ et } \frac{f''(q_0)}{2} \cdot (q - q_0)^2$$

dans lesquels f'($q_0$) est la dérivée première de la fonction d'usure (f(q)) au point de développement ($q_0$) et f''($q_0$) est la dérivée seconde de la fonction d'usure (f(q)) au point de développement ($q_0$).

**10.** Procédé selon l'une des revendications précédentes,
**caractérisé en ce que**
la grandeur d'usure ($Q_v$), est proportionnelle à la capacité initiale ($Q_n$) d'un accumulateur d'énergie neuf, de même type.

**11.** Procédé selon l'une des revendications 7 à 10,
**caractérisé en ce qu'**
on calcule la grandeur d'usure ($Q_v$) à partir du produit de la fonction d'usure (f(q)) et de la capacité initiale ($Q_n$) de l'accumulateur d'énergie neuf de même type.

**12.** Procédé selon l'une des revendications précédentes,
**caractérisé en ce qu'**
on détermine une valeur caractéristique de la capacité d'accumulation actuelle ($Q_{ist}$) de l'accumulateur d'énergie à partir de la différence entre la capacité initiale ($Q_n$) de l'accumulateur d'énergie neuf de même type et la grandeur d'usure (Qv).

**13.** Procédé selon l'une des revendications précédentes,
**caractérisé en ce qu'**
on combine la grandeur d'usure ($Q_v$) à d'autres grandeurs d'état décrivant l'état de l'accumulateur d'énergie.

**14.** Accumulateur d'énergie, notamment batterie de démarreur de véhicule comportant des moyens de mesure pour déterminer la quantité de charge convertie ($q_L$) au cours des cycles de charge de l'accumulateur d'énergie ainsi que des moyens de calcul,

**caractérisé en ce que**

les moyens de calcul sont réalisés pour calculer une grandeur d'usure ($Q_v$), caractérisant la perte en capacité d'accumulation comme fonction de la quantité de charge convertie ($q_L$), déterminée selon le procédé de l'une des revendications précédentes.

Fig. 1

**IN DER BESCHREIBUNG AUFGEFÜHRTE DOKUMENTE**

*Diese Liste der vom Anmelder aufgeführten Dokumente wurde ausschließlich zur Information des Lesers aufgenommen und ist nicht Bestandteil des europäischen Patentdokumentes. Sie wurde mit größter Sorgfalt zusammengestellt; das EPA übernimmt jedoch keinerlei Haftung für etwaige Fehler oder Auslassungen.*

**In der Beschreibung aufgeführte Patentdokumente**

- DE 19540827 C2
- DE 3901680 C3
- DE 3808559 C2